# EUROPEAN PATENT SPECIFICATION

(11) **EP 1 298 971 B1**
(45) Date of publication and mention of the grant of the patent: **21.02.2007**
(21) Application number: 02021806.1
(22) Date of filing: 26.09.2002
(51) Int. Cl.: H05K 3/30, H05K 7/14, H05K 7/12

(54) **Structure for circuit board mounting**
Aufbau beim Montieren einer Schaltungsplatte
Structure pour le montage d'une plaquette à circuits

(30) Priority: 27.09.2001 JP 2001296200
(43) Date of publication of application: 02.04.2003
(73) Proprietor: Calsonic Kansei Corporation, Tokyo (JP)
(72) Inventor: Koike, Hitoshi, Calsonic Kansei Corporation, Nakano-ku, Tokyo (JP)
(74) Representative: Grünecker, Kinkeldey, Stockmair & Schwanhäusser Anwaltssozietät

(56) References cited:
- US-A- 3 324 226
- US-A- 4 684 093
- US-A- 5 580 203
- US-A- 6 095 822
- US-B1- 6 260 265

## Description

The present invention relates to a circuit board according to the preamble portion of claim 1.

An instrument having a speedometer, a tachometer, a fuel gauge, a water temperature gauge, and the like is attached in a vehicle such as an automobile.

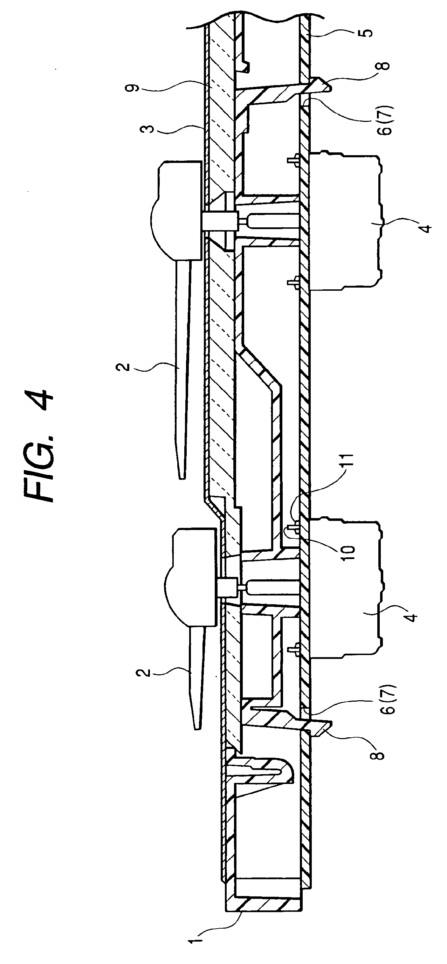

Such an instrument has a structure shown in Fig. 4. A dial plate 3 in which a letter/scale portion is formed along an area where each of pointers 2 is swung is attached to a surface of a mounting part 1 such as a case. A circuit board 5 having circuit components such as movements 4 for swinging the pointers 2 is attached to the rear face of the mounting part 1 such as a case.

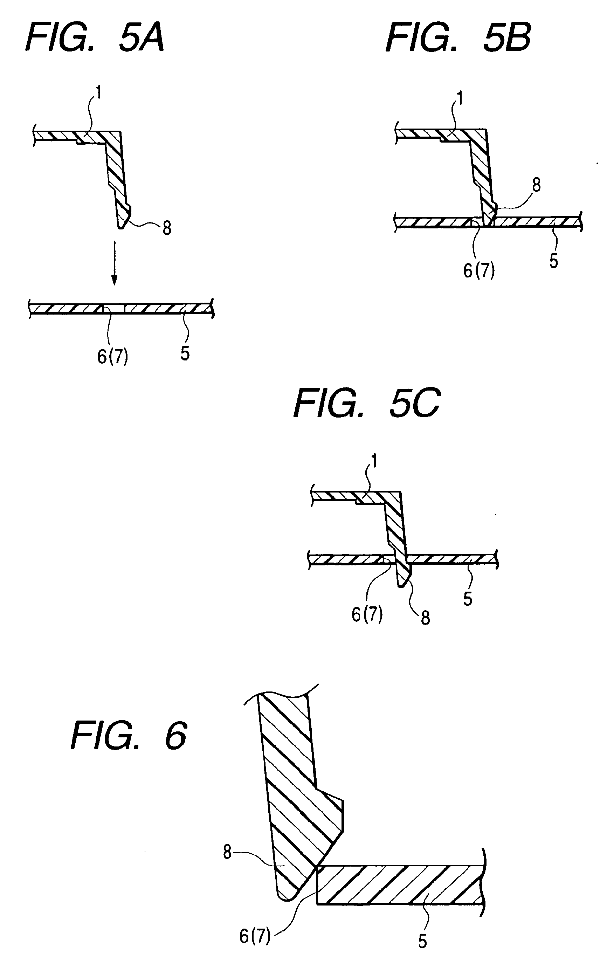

Engagement portions 7 such as engagement holes 6 or engagement notches are formed in the circuit board 5. Engagement claws 8 protrude from the mounting part 1. As shown in Figs. 5A to 5C, the engaging claws 8 are engaged with the engagement portions 7, respectively, to attach the circuit board 5 to the mounting part 1.

In Fig. 4, the reference numeral 9 denotes a light guide plate which guides light emitted from a light source (not shown) to the letter/scale portions of the dial plate 3, base portions of the pointers 2, and the like. Reference numeral 10 denotes electrical connecting pins which elongate from the movements 4. Reference numeral 11 denotes solder for electrically connecting the electrical connecting pins 10 to the circuit board 5.

In the structure for the circuit board attaching portion according to the related art, usually, the engagement portions 7 of the circuit board 5 are formed by a punching operation in press working, and hence edge portions have acute angles. Moreover, the mounting part 1 such as a soft case, which is produced by, for example, injection-molding a PP composite material, is different in hardness from the hard circuit board 5, which is formed by stacking an epoxy resin, a paper phenol resin, and the like. Because of these reasons, when the engaging claws 8 are engaged with the engagement portions 7, a catch due to, for example, a bite between the edge portion of the engagement portion 7 and an inclined guide face, which is formed in a tip end of the engaging claws 8 occurs as shown in Fig. 6. This impairs the efficiency of the attaching work. There arises the possibility that, during the attaching work, this catch causes the harder circuit board 5 to crack or whittling to be produced.

From US 6,260,265 there is known a stiffener for a circuit board, wherein the stiffener is fastened to one side surface of the circuit board by several fasteners penetrating through holes provided in the circuit board.

Further, US 3,324,226 discloses mountings for electronic components on printed circuit boards or on a chassis.

It is an object of the invention to provide a circuit board as indicated above having a structure for a circuit board attaching portion in which the above-discussed problem can be solved, the efficiency of the attaching work can be improved, and the circuit board 5 can be prevented from cracking.

This objective is solved by a circuit board having an engagement portion for attachment to a mounting part by engaging an engaging claw of the mounting part with the engagement portion of the circuit board, wherein a build up portion is provided as a catch preventing portion on an edge portion of the engagement portion, on the side of the circuit board facing the mounting part.

Accordingly, there is provided a circuit board having an attaching portion on which an engagement portion is formed, and a mounting part in which an engaging claw is formed. The circuit board is attached to the mounting part by engaging the engaging claw with the engagement portion. A catch preventing portion, which prevents the engaging claw from being caught, is formed on a side of a mounting part attached face of the engaged portion.

Furthermore, the catch preventing portion is formed on a side of a mounting part attached face of the engagement portion. Even when an edge portion of the engagement portion has an acute angle or even when there is a difference in hardness between the circuit board and the mounting part, the catch preventing portion effectively prevents a catch between the engagement portion and the engaging claw from occurring. Therefore, the efficiency of the attaching work can be improved and the circuit board can be prevented from cracking.

Likewise, the catch preventing portion is a build up portion, which is formed on the edge portion of the engagement portion.

Since the build up portion is formed as the catch preventing portion on the edge portion of the engagement portion, the edge portion of the engagement portion can be dulled so that a catch between the engagement portion and the engaging claw can be prevented more effectively from occurring.

Preferably, the build up portion is a solder.

Since the build up portion is a solder, the edge portion of the engagement portion can be easily dulled so that a catch between the engagement portion and the engaging claw can be effectively prevented from occurring.

Further preferably, the solder is disposed on a land, which is formed on the edge portion of the engagement portion.

Since the solder is disposed on a land, which is formed on the edge portion of the engagement portion, the solder can be effectively disposed.

Still further preferably, the solder is formed concurrently with soldering of a circuit component onto the circuit board.

Since the solder of the build up portion is formed concurrently with soldering of a circuit component onto the circuit board, it is not required to particularly form the catch preventing portion and hence additional production costs can be suppressed.

In the following, the present invention is explained in greater detail with respect to the several embodiments thereof in conjunction with the accompanying drawings, wherein
Fig. 1 is a side section view of an embodiment,
Fig. 2 is a perspective view showing an attaching state of a mounting part and a circuit board,
Fig. 3 is an enlarged side view showing main portions of the attaching state of the mounting part and the circuit board in the embodiment,
Fig. 4 is a side section view of the related art,
Figs. 5A to 5C are enlarged side views showing a step of attaching the circuit board to the mounting part, and
Fig. 6 is an enlarged side view showing main portions of an attaching state of a mounting part and a circuit board in the related art.

Hereinafter, a specific embodiment will be described with reference to an illustrated example.

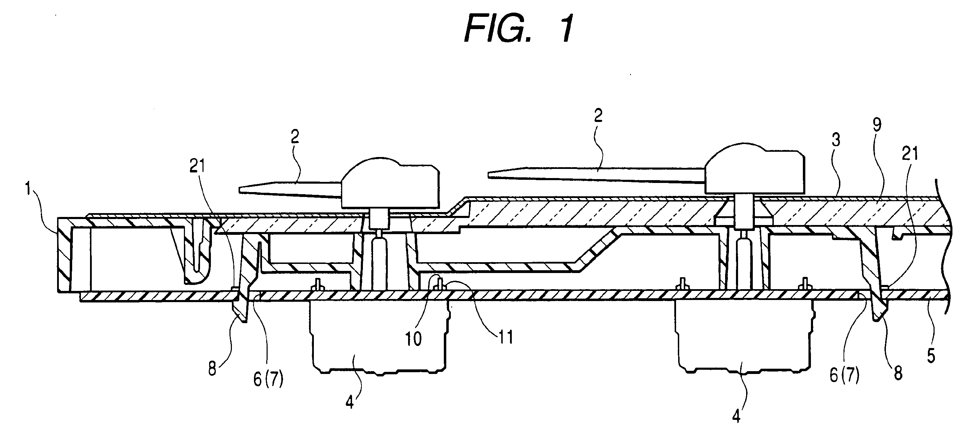

Figs. 1 to 3 show a structure comprising a circuit board 5 and a mounting part in accordance with the present invention. Parts identical or equivalent to those of the related art are denoted by the same reference numerals.

A configuration of the embodiment first will be described. An instrument having a speedometer, a tachometer, a fuel gauge, a water temperature gauge, and the like is attached in a vehicle such as an automobile.

Such an instrument has a structure shown in Fig. 1. A dial plate 3 in which a letter/scale portion is formed along an area where each of pointers 2 is swung is attached to a surface of a mounting part 1 such as a case. A circuit board 5 having movements 4 for swinging the pointers 2 and electronic control circuit components are attached to the rear face of the mounting part 1 such as a case.

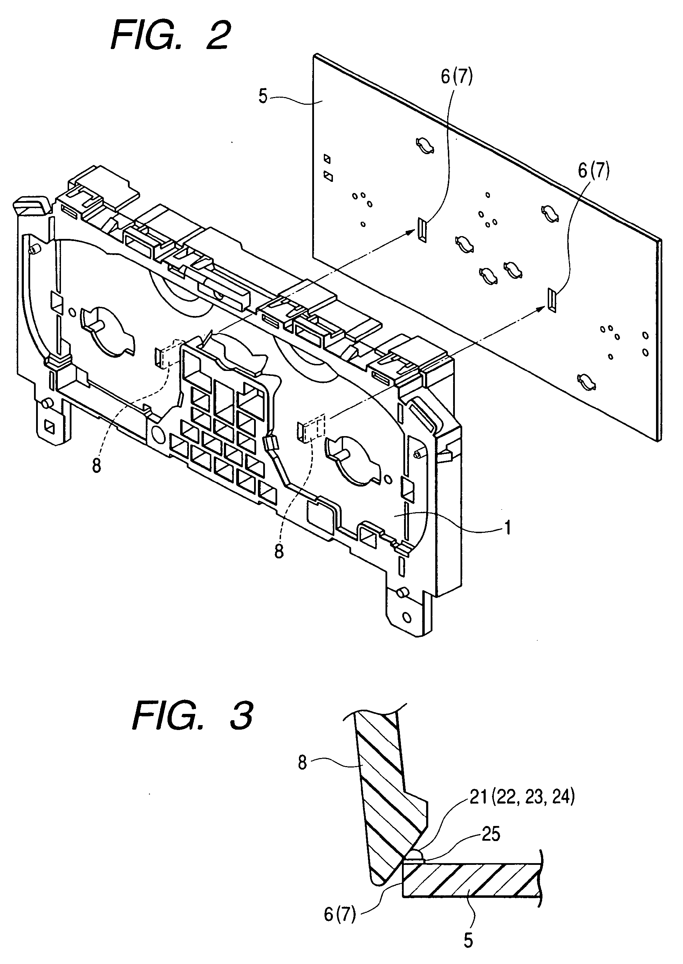

Engagement portions 7 such as engagement holes 6 or engagement notches are formed in the circuit board 5. Engaging claws 8 protrude from the mounting part 1. As shown in Fig. 2, the engagement claws 8 are engaged with the engagement portions 7, respectively, to attach the circuit board 5 to the mounting part 1.

In Fig. 1, the reference numeral 9 denotes a light guide plate which guides light emitted from a light source (not shown) to the letter/scale portions, base portions of the pointers 2, and the like. Reference numeral 10 denotes electrical connecting pins, which elongate from the movements 4. Reference numeral 11 denotes solder for electrically connecting the electrical connecting pins 10 to the circuit board 5.

As shown in Fig. 3, a catch preventing portion 21 which prevents the engagement claw 8 from being caught is formed on the side of the circuit board 5 facing the mounting part.

In one embodiment, the catch preventing portion 21 is an edge dulling portion 22 which is formed on an edge portion of the engagement portion 7.

The edge dulling portion 22 may be configured in various manners, and, for example, by chamfering the edge portion of the engagement portion 7. In the present invention, the catch preventing portion 21 is configured by forming a build up portion 23 on the edge portion of the engagement portion 7.

The build up portion 23 may be configured in various manners, and, for example, by heaping an adhesive agent, a coating material, or a photoresist which is formed on the surface of the circuit board 5. In a further embodiment, the build up portion 23 is a solder 24.

A land 25 is formed on the edge portion of the engagement portion 7, and the solder 24 is then disposed on the land 25.

The solder 24 is formed concurrently with soldering of the circuit components onto the circuit board 5.

Next, an effect of the present invention will be described.

Even when the edge portion of the engagement portion 7 has an acute angle, or even when there is a difference in hardness between the circuit board 5 and the mounting part 1, the formation of the catch preventing portion 21 on the side of the mounting part-attached face of the engagement portion 7 prevents the inclined guide face of the engaging claw 8 from directly contacting with the acute edge of the engagement portions 7 and effectively prevents a catch between the engagement portion 7 and the engagement claw 8 from occurring. Therefore, the efficiency of the attaching work can be improved and the circuit board 5 can be prevented from cracking.

Since the edge dulling portion 22 is formed as the catch preventing portion 21 on the edge portion of the engagement portion 7, it is possible to prevent more effectively a catch between the engagement portion 7 and the engaging claw 8 from occurring.

During the attaching process, moreover, the inclined face of the engagement claw 8 is not whittled by the edge portion of the engagement portion 7. Therefore, it is possible to prevent whittling from being produced.

Since the build up portion 23 is formed as the edge dulling portion 22 on the edge portion of the engagement portion 7, the edge portion of the engagement portion 7 can be dulled. Therefore, a catch between the engagement portion 7 and the engaging claw 8 can be prevented more effectively from occurring.

Since the build up portion 23 is a solder 24, the edge portion of the engagement portion 7 can be easily dulled. Therefore, a catch between the engagement portion 7 and the engaging claw 8 can be prevented more effectively from occurring.

When the solder 24 is disposed on the land 25 which is formed on the edge portion of the engagement portion 7, the solder 24 can be effectively disposed.

Since the solder 24 of the build up portion 23 is formed concurrently with soldering of the circuit components onto the circuit board 5, it is not required to add a special process such as a process of chamfering the edge of the engagement portions 7. Therefore, additional production cost due to this special process can be suppressed.

In the embodiment described above, the engagement holes 6 or engagement notches are formed as the engagement portions 7. It is a matter of course that the outer peripheral edge of the circuit board 5 may be used as the engagement portions 7.

As described above, according to the present embodiment the catch preventing portion is formed on the side of the mounting part attached face of the engagement portion. Even when the edge portion of the engagement portion has an acute angle or even when there is a difference in hardness between the circuit board and the mounting part, the catch preventing portion effectively prevents a catch between the engagement portion and the engagement claw from occurring. Therefore, the efficiency of the attaching work can be improved and the circuit board can be prevented from cracking.

Further, as described above, according to another embodiment, since the edge dulling portion is formed as the catch preventing portion on the edge portion of the engagement portion, it is possible to prevent more effectively a catch between the engagement portion and the engaging claw from occurring.

Still further, as described above, according to the present embodiment, since the build up portion is formed as the catch preventing portion on the edge portion of the engagement portion, the edge portion of the engagement portion can be dulled so that a catch between the engagement portion and the engaging claw can be prevented more effectively from occurring.

Yet further, as described above, according to a further embodiment, since the build up portion is a solder, the edge portion of the engagement portion can be easily dulled so that a catch between the engagement portion and the engaging claw can be effectively prevented from occurring.

Moreover, according to the further embodiment, since the solder is disposed on a land, which is formed on the edge portion of the engagement portion, the solder can be effectively disposed.

Likewise, according to the further embodiment, since the solder of the build up portion is formed concurrently with soldering of a circuit component onto the circuit board, it is not required to particularly form the catch preventing portion. Therefore, it is possible to exert a practically useful effect that additional production costs can be suppressed.

## Claims

1. Circuit board (5) having an engagement portion (6,7) for attachment to a mounting part (1) by engaging an engaging claw (8) of the mounting part (1) with the engagement portion (6,7) of the circuit board (5),
**characterized in that**
a build up portion (23) is provided as a catch preventing portion (21) on an edge portion of the engagement portion (6,7), on the side of the circuit board (5) facing the mounting part (1).

2. Circuit board according to claim 1, **characterized in that** the build up portion (23) is a solder (24).

3. Circuit board according to claim 2, **characterized in that** the solder (24) is disposed on a land (25), which is formed on the edge portion of the engagement portion (6,7).

4. Circuit board according to claim 2 or 3, **characterized in that** the solder (24) is formed concurrently with soldering of a circuit component onto the circuit board (5).

## Patentansprüche

1. Leiterplatte (5), die einen Eingriffsabschnitt (6, 7) zur Verbindung mit einem Montageteil (1) durch Eingriff einer Eingriffsklaue (8) des Montageteiles (1) mit dem Eingriffsabschnitt (6, 7) der Leiterplatte (5) aufweist,
**dadurch gekennzeichnet, daß**
ein Aufbauabschnitt (23) als ein Angriffs-Veränderungsabschnitt (21) an einem Kantenabschnitt des Eingriffsabschnittes (6, 7) auf der Seite der Leiterplatte (5), der dem Montageteil (1) zugewandt ist.

2. Leiterplatte (5) nach Anspruch 1, **dadurch gekennzeichnet, daß** der Aufbauabschnitt (23) ein Weichlot (24) ist.

3. Leiterplatte nach Anspruch 2, **dadurch gekennzeichnet, daß** das Weichlot (24) auf einer Zunge (25) angeordnet ist, die an einem Kantenabschnitt des Eingriffsabschnittes (6, 7) ausgebildet ist.

4. Leiterplatte nach Anspruch 2 oder 3, **dadurch gekennzeichnet, daß** das Weichlot (24) gleichzeitig mit dem Verlöten einer Leiterplattenkomponente auf der Leiterplatte (5) ausgebildet wird.

## Revendications

1. Carte de circuit imprimé (5) ayant une partie de prise (6, 7) pour fixation sur une partie de montage (1) en faisant venir en prise une griffe de prise (8) de la partie de montage (1) avec la partie de prise (6, 7) de la carte de circuit imprimé (5),
**caractérisée en ce que**
une partie ajoutée (23) est placée comme partie anti-accrochage (21) sur une partie de bord de la partie de prise (6, 7), sur le côté de la carte de circuit imprimé (5) dirigé vers la partie de montage (1).

2. Carte de circuit imprimé selon la revendication 1, **caractérisée en ce que** la partie ajoutée (23) est une soudure 24.

3. Carte de circuit imprimé selon la revendication 2, **caractérisée en ce que** la soudure (24) est disposée sur une pastille (25), qui est formée sur la partie de bord de la partie de prise (6, 7).

4. Carte de circuit imprimé selon la revendication 2 ou 3, **caractérisée en ce que** la soudure (24) est formée concurremment avec la soudure d'un composant de circuit sur la carte de circuit imprimé (5).
